(19) Europäisches Patentamt
European Patent Office
Office européen des brevets

(11) **EP 0 765 028 A2**

(12) **EUROPEAN PATENT APPLICATION**

(43) Date of publication:
26.03.1997 Bulletin 1997/13

(51) Int Cl.[6]: **H03F 1/26**

(21) Application number: 96306403.5

(22) Date of filing: 04.09.1996

(84) Designated Contracting States:
AT DE ES FR GB IT

(30) Priority: 20.09.1995 GB 9519233

(71) Applicant: PLESSEY SEMICONDUCTORS
LIMITED
Swindon, Wiltshire SN2 2QW (GB)

(72) Inventor: Madni, Arshad
Swindon, Wilts. SN3 2HA (GB)

(74) Representative: Hoste, Colin Francis
The General Electric Company p.l.c.
GEC Patent Department
Waterhouse Lane
Chelmsford, Essex CM1 2QX (GB)

(54) **Amplifier arrangements**

(57) Amplifier arrangements having low noise, low distortion and controlled input impedance, suitable for front-end radio frequency integrated circuits, in each of which a negative feedback path utilising two impedance elements of like argument is provided between output and input to control the input impedance.

Fig. 1

## Description

The present invention relates to amplifier arrangements, and in particular although not exclusively to amplifier arrangements for front-end radio frequency integrated circuit applications, where the requirements of low noise, low distortion and controlled input impedance place stringent constraints on the choice of architecture.

According to a first aspect of the present invention an amplifier arrangement includes a transistor having emitter, base and collector electrodes, means for applying an input signal to the emitter electrode of said transistor, output circuit means connected to the collector electrode of said transistor, and negative feedback means comprising first and second impedance elements having impedance values substantially of like argument, means connecting the first impedance element in series in a path between the base electrode of said transistor and a point of reference potential and means connecting the second impedance element in series in a path between a point in said output circuit means and the base electrode of said transistor.

The output circuit means may comprise a second transistor connected as an emitter follower stage, and said point in said output circuit means may comprise a point in the emitter circuit of said emitter follower stage.

According to a second aspect of the present invention an amplifier arrangement includes a first transistor of a first conductivity type having emitter, base and collector electrodes, means for applying an input signal to the emitter electrode of said first transistor, a second transistor of a second conductivity type having emitter, base and collector electrodes, means connecting said second transistor as a current source in the collector circuit of said first transistor, and negative feedback means comprising first and second impedance elements having impedance values substantially of like argument, means connecting the first impedance element in series in a path between the base electrode of the first transistor and a point of reference potential and means connecting the second impedance element in series in a path between the collector circuit of said first transistor and the base electrode of said first transistor.

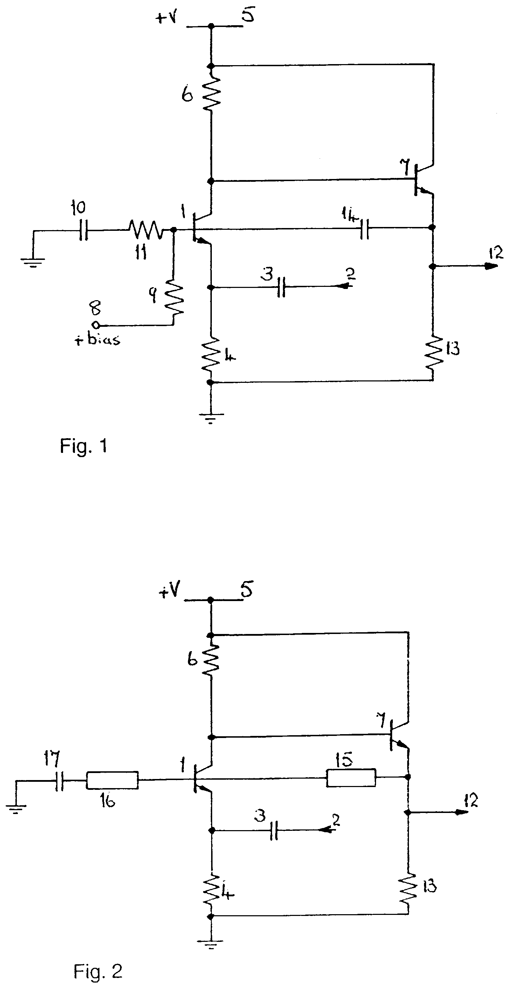

Amplifier arrangements in accordance with the present invention will now be described by way of example with reference to the accompanying drawings, of which Figures 1 to 4 show respective different embodiments of the invention.

Referring first to Figure 1 one amplifier arrangement in accordance with the invention comprises an npn junction transistor 1 having its emitter electrode connected to an input path 2 by way of a coupling capacitor 3 and to ground by way of a resistor 4, its collector electrode connected to a positive supply line 5 by way of a load resistor 6 and to the base electrode of an npn transistor 7, and its base electrode connected to a source 8 of bias potential by way of a resistor 9 and to ground by way of a capacitor 10 and a resistor 11 in series. The collector electrode of the transistor 7 is connected to the supply line 5, and its emitter electrode is connected to an output path 12, to ground by way of a resistor 13 and to the base electrode of the transistor 1 by way of a capacitor 14.

The transistor 1, which is connected to operate in common base mode, forms the basis of the amplifier "cell" for operation at a frequency, say, of the order of 1GHz, with an input impedance of the order of 75 ohms and a voltage gain of 4. Voltage feedback from the output path 12 is provided by way of capacitors 14 and 10, which may for example have values of 1pF and 3pF respectively. The resistor 11 is included to compensate for a small value negative resistance which occurs at high frequencies due to the product beta and the parallel combination of the capacitors 10 and 14.

A more general representation of the amplifier circuit arrangement is shown in Figure 2, where the feedback capacitors 14 and 10 are replaced by impedances 15 and 16 respectively, other components being given the same references as in Figure 1 where appropriate. These impedances may be both resistors or both inductors, a capacitor 17 providing a d.c. block of negligible impedance at the operating frequencies. For the circuit of Figure 2 the impedance Zx looking into the emitter electrode of the transistor 1, the input impedance Zin of the amplifier arrangement, the voltage gain Gv of the amplifier arrangement and the third harmonic distortion D3 of the first stage are given by:-

$$Zx = re + \frac{Z_{16} \parallel Z_{15}}{\beta} + \frac{R_6}{1 + \frac{Z_{16}}{Z_{15}}}$$

$$Zin = Zx \parallel R_4$$

- where Vin is the input voltage at the emitter electrode of transistor 1, Vt is the thermal

$$D3 = \left(\frac{Vin}{Vt}\right)^2 \cdot \frac{1}{12} \cdot \frac{1}{\left(1 + \frac{Zin}{re}\right)^3}$$

$$Gv = \frac{R_6}{Zin}$$

voltage associated with the base emitter junction of transistor 1, and re is the emitter/base impedance defined as Vt/emitter current.

The value of resistor 4 is made as large as possible for the selected value of emitter current into transistor 1, in order to reduce shunting of the input. In a particular example with a nine volt supply on line 5 the value of resistor 4 was made 300 ohms.

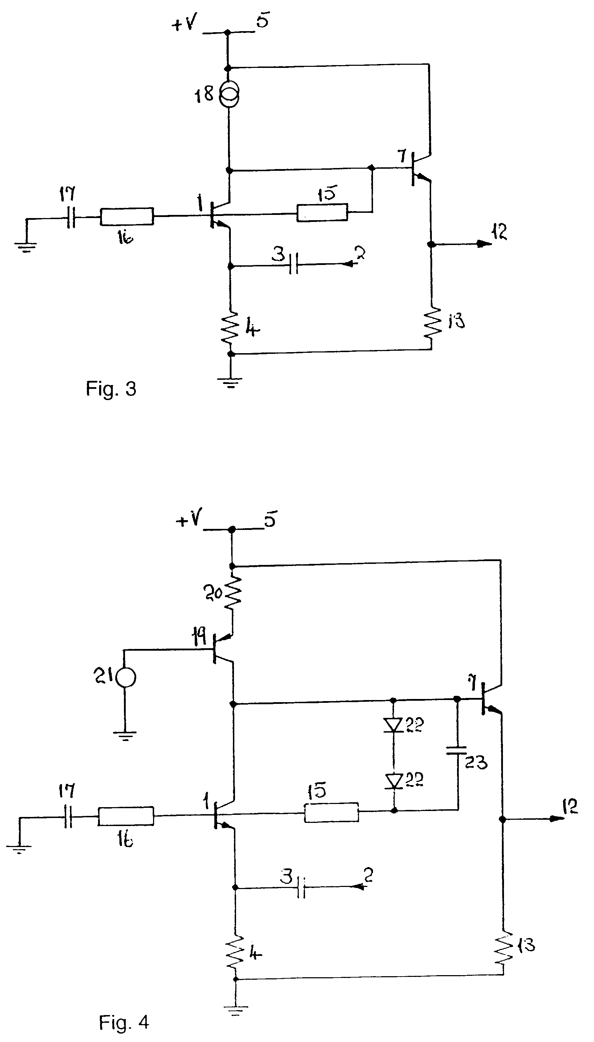

A variant of the amplifier arrangement utilising complementary transistors is indicated in generalised form in Figure 3 and as implemented in Figure 4. In this form the load resistor 6 is replaced by a current source 18, which may comprise a pnp transistor 19, an emitter resistor 20 and abase bias source 21, and the feedback is taken from the collector electrode of the transistor 1. As shown in Figure 4, forward biased diodes 22 may be included in the feedback path to effect a required dc voltage drop, these diodes being by-passed at the operating frequency by a capacitor 23. The circuit of Figure 4 is easier to tailor to given requirements and offers higher linearity, the input impedance Zin and gain Gv being given by:-

$$Zin = ( re + Z_{16} ) \parallel R_4$$

$$Gv = 1 + \frac{Z_{15}}{Z_{16}}$$

The equation for third harmonic distortion D3 remains the same as for the circuits of Figures 1 and 2.

## Claims

1. An amplifier arrangement including a transistor having emitter, base and collector electrodes, means for applying an input signal to the emitter electrode of said transistor, output circuit means connected to the collector electrode of said transistor, and negative feedback means comprising first and second impedance elements having impedance values substantially of like argument, means connecting the first impedance element in series in a path between the base electrode of said transistor and a point of reference potential and means connecting the second impedance element in series in a path between a point in said output circuit means and the base electrode of said transistor.

2. An amplifier arrangement in accordance with Claim 1 wherein the output circuit means comprises a current source connected in the collector circuit of said transistor and said second impedance element is connected between the collector circuit of said transistor and the base electrode of said transistor.

3. An amplifier arrangement in accordance with Claim 1 wherein the output circuit means comprises a second transistor connected as an emitter follower stage, and said point in said output circuit means comprises a point in the emitter circuit of said emitter follower stage.

4. An amplifier arrangement including a first transistor of a first conductivity type having emitter, base and collector electrodes, means for applying an input signal to the emitter electrode of said first transistor, a second transistor of a second conductivity type having emitter, base and collector electrodes, means connecting said second transistor as a current source in the collector circuit of said first transistor, and negative feedback means comprising first and second impedance elements having impedance values substantially of like argument, means connecting the first impedance element in series in a path between the base electrode of the first transistor and a point of reference potential and means connecting the second impedance element in series in a path between the collector circuit of said first transistor and the base electrode of said first transistor.

5. An amplifier arrangement in accordance with any preceding claim wherein the first and second impedence elements are capacitors.

Fig. 1

Fig. 2

Fig. 3

Fig. 4